# DEMANDE DE BREVET EUROPEEN

(11) **EP 1 693 338 A1**
(43) Date de publication de la demande: **23.08.2006**
(21) Numéro de dépôt: 05405198.2
(22) Date de dépôt: 17.02.2005
(51) Int. Cl.: B81C 1/00, G03F 7/11

(54) **Procédé de réalisation d'une micro-structure en titane.**

(71) Demandeur: CSEM Centre Suisse d'Electronique et de Microtechnique S.A. - Recherche et Développement, 2007 Neuchâtel (CH)
(72) Inventeur: Cardot, Françis, 2000 Neuchâtel (CH)
(74) Mandataire: GLN

(57) **Abrégé**

L'invention concerne un procédé de réalisation d'une micro-structure, comportant les principales étapes suivantes :
- se doter d'un substrat (10) comportant au moins une couche de titane superficielle,
- déposer une couche de métal (14) sur le substrat (10),
- former, sur cette couche de métal (14), un premier masque (16) dont la forme correspond à celle de la micro-structure (20, 22) désirée,
- remplir d'un même métal (18) les ouvertures du masque (16),
- éliminer le premier masque (16) et les portions de la couche de métal (14) situées sous lui afin d'obtenir un deuxième masque (18) de ce métal, et
- effectuer, au travers de ce deuxième masque (18), un traitement des surfaces de titane découvertes, afin de réaliser la micro-structure (20, 22).

## Description

L'invention se rapporte au domaine de la microtechnique. Elle concerne, plus particulièrement, un procédé de réalisation d'une micro-structure à base de titane.

L'invention trouve des applications intéressantes pour la réalisation de systèmes microfluidiques destinés, notamment, au domaine médical, de substrats tridimensionnels servant de moules pour la croissance de structures détachables, d'implants dotés d'une surface rugueuse, etc.

Le titane est un matériau présentant une grande résistance à la corrosion et aux attaques par des agents chimiques de type acide ou solvant, ce qui en fait un matériau hautement biocompatible. Il est, de ce fait, très utilisé pour la réalisation de dispositifs médicaux, en particulier, des implants corporels et dentaires. De plus, la possibilité de doter l'implant de micro-cavités améliore grandement l'adhérence des cellules. Plus généralement, le titane est un matériau idéal pour la réalisation de micro-systèmes destinés à toute utilisation en milieu agressif.

Quel que soit l'emploi du titane, il est essentiel d'en maîtriser le micro-usinage qui, à ce jour, repose sur des méthodes mécaniques classiques, des usinages au laser, des usinages chimiques ou des gravures électrochimiques.

Cette dernière méthode, bien connue de l'homme de métier, est la plus efficace en vue d'obtenir une grande précision des motifs gravés. Elle consiste en une électroérosion de la surface de titane, à travers un masque de résine, par un électrolyte formé d'un mélange d'acide sulfurique et de méthanol. Cette technique est, néanmoins, limitée par la résistance du masque de résine lui-même à l'électrolyte. Un seul type de résine, en effet, présente une résistance à la gravure par l'électrolyte suffisante pour permettre son utilisation, pendant une durée restreinte, et à condition que son épaisseur soit assez importante (de l'ordre de 5 microns). Cette résine à base de polyimide, de type négatif, permet d'atteindre des dimensions latérales de structures de l'ordre de 5 microns pour une épaisseur équivalente. De ce fait, la gravure du titane est limitée en terme de largeur et de profondeur des structures.

La présente invention a pour but de remédier à cet inconvénient en utilisant un procédé de masquage extrêmement résistant à l'électrolyte de gravure électrochimique du titane et permettant la réalisation de structures de haute définition.

De façon plus précise, l'invention concerne un procédé de réalisation d'une micro-structure, caractérisé en ce qu'il comporte les principales étapes suivantes :
- se doter d'un substrat comportant au moins une couche de titane superficielle,
- déposer une couche de métal sur ce substrat,
- former sur la couche de métal un premier masque dont la forme correspond à celle de la micro-structure désirée,
- remplir du même métal les ouvertures du masque,
- éliminer le premier masque et les portions de la couche de métal situées sous lui afin d'obtenir un deuxième masque de métal, et
- effectuer au travers de ce deuxième masque un traitement des surfaces de titane découvertes par l'élimination de la couche, afin de réaliser la micro-structure.

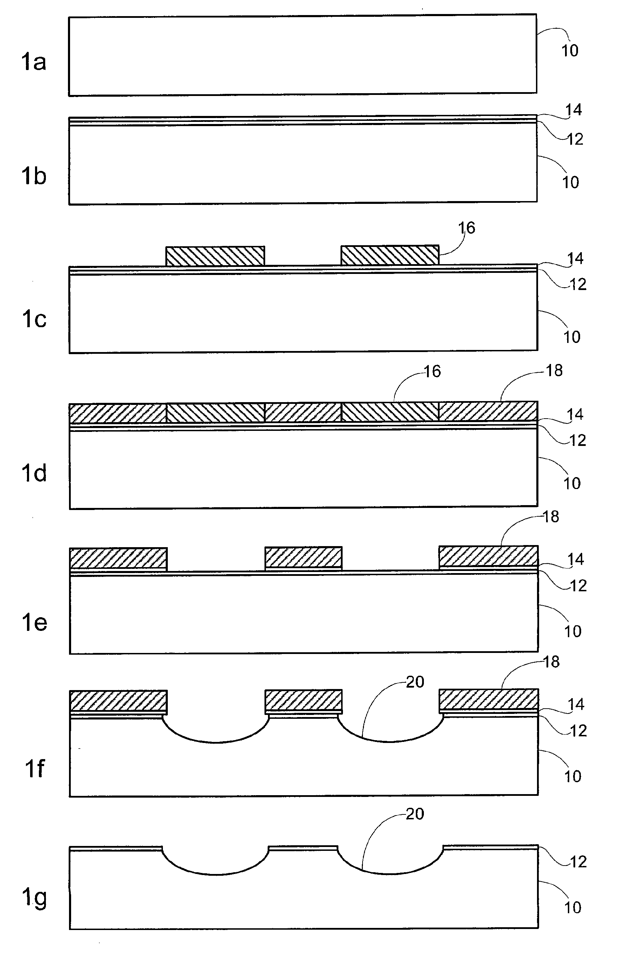

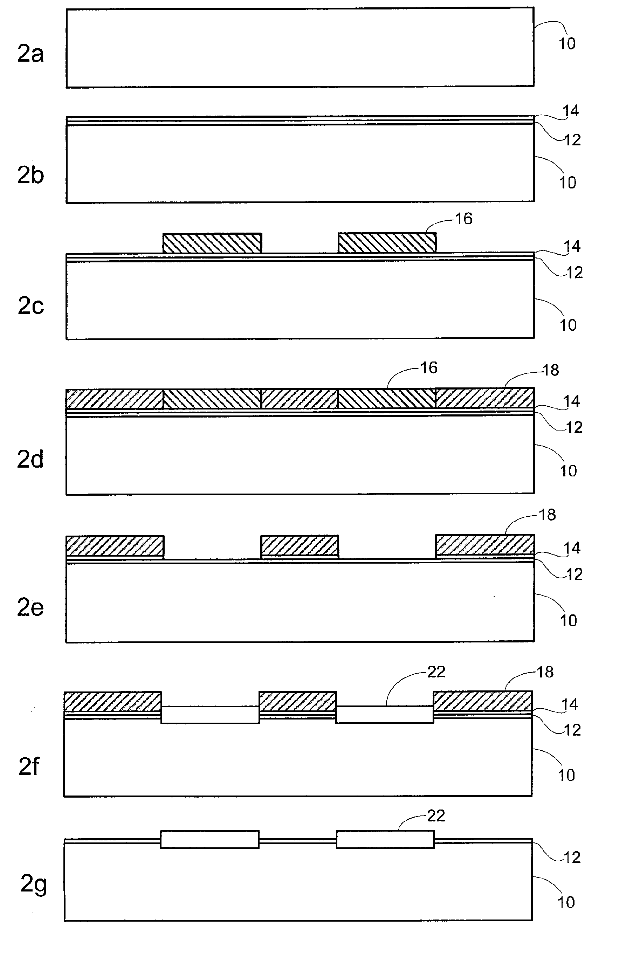

D'autres caractéristiques de l'invention apparaîtront plus clairement à la lecture de la description qui suit, faite en référence aux dessins annexés, dans lesquels les figures 1 et 2 illustrent schématiquement les principales étapes (référencées de a à g) de deux modes de mise en oeuvre du procédé. Il est entendu que, sur ces figures, les échelles ne sont pas respectées afin d'en faciliter la lecture.

On se référera tout d'abord à la figure 1 relative au premier mode.

### Figure 1a

La première étape du procédé consiste à se munir d'un substrat 10 avantageusement formé d'une plaque de titane. Eventuellement, cette plaque peut être disposée sur une base réalisée en un autre matériau.

### Figure 1b

Le substrat 10 est recouvert, par une technique d'évaporation bien connue de l'homme de métier, d'une couche de titane 12 d'environ 0.2 micron et d'une couche d'or 14 d'environ 0.1 micron, sans mise à l'air entre les deux dépôts. La couche de titane 12 sert de couche d'accrochage à la couche d'or 14. En effet, le titane s'oxyde spontanément à l'air et l'or présente une mauvaise adhérence à l'oxyde de titane. C'est pourquoi, la couche de titane 12 est nécessaire avant le dépôt d'or.

### Figure 1c

Une couche de résine, de type positif, est déposée sur la couche d'or 14, puis structurée selon un procédé photo-lithographique standard de façon à constituer un premier masque 16, dont la forme définit celle des surfaces du substrat de titane 10 à traiter ultérieurement.

### Figure 1d

Une couche d'or galvanique 18, d'épaisseur comprise entre 0.5 micron et 5 microns, est déposée sur la couche d'or 14, uniquement dans les ouvertures du masque 16. De la sorte, la couche d'or galvanique 18 forme le négatif du masque de résine.

### Figure 1e

Le masque de résine 16 est éliminé par dissolution dans un solvant ou par attaque dans de l'acide sulfurique, laissant apparaître la couche d'or 14 initialement sous la résine et faisant ressortir les structures formées par la couche d'or galvanique 18.

Puis, la couche d'or 14 est attaquée, aux emplacements où elle est apparente, dans une solution d'iode-iodure de potassium, encore appelée 'or-etch'. L'attaque doit être suffisamment brève pour ne pas amincir significativement la couche d'or galvanique 18, du fait du rapport (entre 5 et 50) des épaisseurs entre les deux couches. On notera que la solution utilisée, grâce à sa sélectivité, est pratiquement sans effet sur la couche inférieure de titane 12.

La couche d'or 18 forme ainsi un deuxième masque destiné à résister au traitement ultérieur.

### Figure 1f

L'ensemble est attaqué par voie électrochimique dans un électrolyte standard. Les zones recouvertes du masque d'or 18 résistent à cette attaque, et la gravure se limite aux zones non protégées. Ainsi, la couche de titane 12 disparaît en ces zones et des micro-cavités 20 sont formées dans le substrat 10.

### Figure 1g

Le masque d'or 18, ainsi que la couche d'or 14 située en dessous, sont éliminés par attaque dans une solution d'iode-iodure de potassium du type de celle utilisée pour l'enlèvement de la couche d'or 14 lors de l'étape 1 e.

On obtient donc, en fin de procédé, une microstructure de titane dont les micro-cavités 20 peuvent avoir toutes les applications ultérieures souhaitées.

On se référera maintenant à la figure 2 qui montre un deuxième mode de mise en oeuvre de l'invention. Les premières étapes de ce procédé, illustrées par les figures 2a à 2e sont identiques à celles des figures 1 a à 1 e.

### Figure 2f

A la différence du premier mode de réalisation, une couche d'oxyde de titane 22 est formée, à travers le masque d'or 18, par oxydation électrochimique. L'électrolyte utilisé est une solution aqueuse d'acide sulfurique. L'oxyde 22 ainsi obtenu est de type anatase, avec une croissance de 2.5 nm par volt appliqué.

### Figure 2g

Le masque d'or 18, ainsi que la couche d'or 14 située en dessous, sont éliminés par attaque dans une solution d'iode-iodure de potassium du type de celle utilisée pour l'enlèvement de la couche d'or 14 lors de l'étape 2e.

Un tel procédé, qui permet la réalisation de microstructures d'oxyde de titane de très grande précision, peut être utilisé pour réaliser des réseaux optiques. Une autre utilisation de ces microstructures 22 est qu'elles peuvent elles-mêmes servir d'éléments de masquage.

Ainsi est proposé un procédé de réalisation d'une micro-structure en titane faisant appel à des opérations de masquage et de gravure. Ce procédé présente essentiellement deux avantages sur le procédé standard.

Premièrement, il permet de réaliser des cavités plus profondes, l'attaque n'étant pas limitée dans le temps, du fait de la résistance de l'or à l'électrolyte. Deuxièmement, les dimensions latérales des structures ne sont plus limitées par l'épaisseur et le type de résine utilisée car celle-ci n'est pas destinée à résister à l'électrolyte de gravure du titane, mais seulement à définir le masque d'or. Elle n'est pas, par conséquent, soumise aux mêmes contraintes, en termes d'épaisseur et de résistance, que la résine utilisée dans le procédé standard. Dès lors, des dimensions de structures typiquement de l'ordre du micron peuvent être atteintes.

La présente invention a été décrite en se référant, à titre d'exemple, à la formation de micro-cavités et de micro-structures en oxyde de titane, mais il va de soi que d'autres structures pourraient être formées, grâce à l'utilisation, par exemple, d'une autre chimie compatible avec un masque d'or.

## Revendications

1. Procédé de réalisation d'une micro-structure, **caractérisé en ce qu'**il comporte les principales étapes suivantes :
- se doter d'un substrat (10) comportant au moins une couche de titane superficielle,
- déposer une couche de métal (14) sur ledit substrat (10),
- former, sur ladite couche de métal (14), un premier masque (16) dont la forme correspond à celle de la micro-structure (20, 22) désirée,
- remplir d'un même métal (18) les ouvertures du masque (16),
- éliminer ledit premier masque (16) et les portions de ladite couche de métal (14) situées sous lui afin d'obtenir un deuxième masque (18) dudit métal, et
- effectuer, au travers de ce deuxième masque (18), un traitement des surfaces de titane découvertes, afin de réaliser ladite micro-structure (20, 22).

2. Procédé selon la revendication 1, **caractérisé en ce que** ledit traitement est réalisé par voie électrochimique.

3. Procédé selon la revendication 2, **caractérisé en ce que** ledit traitement est une gravure électrochimique.

4. Procédé selon la revendication 2, **caractérisé en ce que** ledit traitement est une oxydation électrochimique.

5. Procédé selon l'une des revendications 1 à 4, **caractérisé en ce qu'**une couche de titane (12) est interposée entre ledit substrat (10) et ladite couche de métal (14).

6. Procédé selon l'une des revendications 1 à 5, **caractérisé en ce que** ledit métal (18) est de l'or.

7. Procédé selon l'une des revendications 1 à 6, **caractérisé en ce que** ledit premier masque (16) est réalisé en résine par un procédé de photolithographie.

8. Procédé selon l'une des revendications 1 à 7, **caractérisé en ce que** ledit métal (14, 18) est éliminé après ledit traitement.
